**Europäisches Patentamt**

**European Patent Office**

**Office européen des brevets**

(11) Veröffentlichungsnummer: **0 671 640 A2**

## EUROPÄISCHE PATENTANMELDUNG

(21) Anmeldenummer: **95102806.7**

(22) Anmeldetag: **28.02.95**

(51) Int. Cl.$^6$: **G02B 5/18**, H01L 21/308, G03F 7/00, G02B 6/12, H01S 3/085

(30) Priorität: **09.03.94 DE 4407832**

(43) Veröffentlichungstag der Anmeldung: **13.09.95 Patentblatt 95/37**

(84) Benannte Vertragsstaaten: **CH DE ES FR GB IT LI SE**

(71) Anmelder: **ANT Nachrichtentechnik GmbH Gerberstrasse 33 D-71522 Backnang (DE)**

(72) Erfinder: **Hillmer, Hartmut, Dr. rer. nat. Peter-Behrens-Strasse 12 D-64287 Darmstadt (DE)**

(54) Verfahren zur Herstellung eines Gitters für ein optoelektronisches Bauelements.

(57) 2.1. Die Erfindung dient der Optimierung der Kenngrößen von auf DFB- oder DBR-Gittern basierenden optoelektronischen Bauelementen.

2.2. Erfindungsgemäß wird bei einem optoelektronischen Bauelement, welches mit einer DFB- oder DBR-Gitterstruktur der Gittergrabentiefe (a) versehen ist, nach dem Aufschleudern des Photolacks die Belichtung unter Einbeziehung von Photomasken vorgenommen. Mittels der Photomaske, der Belichtung und der nachfolgenden Entwicklung, werden während des Belichtungsprozesses die Bereiche der Gitterstruktur abgedeckt, die ihre Gitterstruktur behalten sollen. Die als gitterfreie Bereiche auszubildenden Flächen werden mittels eines Ätzverfahrens auf homogene Tiefe abgetragen, wobei die Mindesttiefe des Materialabtrages eine vertikale Ebene erreicht, welche der tiefsten Stellen der Gittergräben entspricht.

2.3. Die erfindungsgemäße Lösung läßt sich insbesondere vorteilhaft bei optoelektronischen Bauelementen, wie Lasern, Laserverstärkern, Filtern, Kopplern und Schaltern einsetzen.

Fig. 1

EP 0 671 640 A2

Die Eigenschaften von optoelektronischen Bauelementen, welche auf DFB- oder DBR-Gittern basieren, wie beispielsweise Laser, Laserverstärker, Filter, Koppler, Detektoren, Multiplexer, Demultiplexer und Schalter, können mit dieser Erfindung verbessert und innerhalb gewisser Grenzen optimiert werden.

Aus der Literatur ist eine erste Gruppe von Lösungen bekannt, welche die Erzeugung einer Variation des Kopplungskoeffizienten in axialer Richtung behandelt.

Eine abrupte Änderung des Kopplungskoeffizienten in longitudinaler Richtung des Bauelements wurde beispielsweise durch partielle Photolack-Remaskierung nach einer Teiltrockenätzung des DFB-Gitters erreicht [z.B. M. Matsuda et al., Conference on InP and related compounds (1991)].

Eine kontinuierliche axiale Variation des Kopplungskoeffizienten K ist durch eine Doppelbelichtung einer auf einer Wafer-Oberfläche aufgetragenen Photolackschicht zu realisieren. Der Photolack enthält nach der Doppel-Belichtung die Information zweier sich überlagernder und sich durchdringender homogener DFB-Gitter, welche sich in ihrer Gitterperiode allerdings um $\Delta\Lambda$ unterscheiden. [A. Talneau et al., Electron. Lett. 28, 1395 (1992)]. Dieses Verfahren ermöglicht abhängig von der Wahl von $\Delta\Lambda$ jeweils nur eine vollständig definierte Funktion K(z) sowie genau eine dazu korrespondierende Bauelementelänge L, wenn die Periodizität der Struktur in Hinblick auf hohe Bauelementausbeute genutzt wird. Die Vorteile, welche eine beliebige Änderung von K(z) bietet, können mit diesem Verfahren nicht genutzt werden.

Aus der Literatur ist weiterhin eine zweite Gruppe von Lösungen bekannt, welche die Erzeugung von einer oder mehreren Phasenverschiebungen über die axiale Verlängerung einer einzigen oder einer kleinen Zahl von Gitterperioden behandelt.

Abhängig von der Höhe der Kopplungskoeffizienten erzeugen abrupte Phasenverschiebungen in DFB-Gittern verschieden starke Photonenzahl-Überhöhungen am Ort der Phasenverschiebung/en, welche manche Eigenschaften optoelektronischer Komponenten negativ beeinflussen können. Realisiert werden abrupte Phasenverschiebungen beispielsweise durch holographische Verfahren [z.B. T. Numai et al., Jap. J. Appl. Phys. 26, L 1910 (1987)] oder mittels Elektronenstrahl-Lithographie (EL).

Die starke Photonenzahl-Überhöhung am Ort, z. B. einer $\lambda/4$ Phasenverschiebung, kann durch das Aufteilen des gesamten Phasenverschiebungs-Betrags auf mehrere örtlich voneinander getrennte Phasenverschiebungs-Anteile (engl. multiple phase-shifts) etwas abgeschwächt werden [z. B. S. Ogita et al. J. Ligthwave Technol 8, 1596 (1990)]. Die einzelnen Teil-Phasenverschiebungen wurden jedoch auch hierbei mittels Elektronenstrahl-Lithographie oder holographischer Methoden abrupt ausgeführt.

Aus der Literatur ist ferner eine dritte Gruppe von Lösungen bekannt, bei denen die Erzeugung von Phasenverschiebungen über die axiale Variation des effektiven Brechungsindex erfolgt.

So werden Phasenverschiebungen beispielsweise auch über eine laterale Aufweitung oder Verengung der Streifenbreite der aktiven Zone bzw. der aktiven Zone und benachbarter Schichten über eine bestimmte Länge der longitudinalen Bauelementelänge realisiert [z. B. H. Soda et al., IEEE J. Quant. Electron. 0E-23, 804 (1987), oder G. Chen et al. Appl. Phys. Lett 60, 2586 (1992)]. Dabei wurde der effektive Brechungsindex in longitudinaler Richtung quasi abrupt geändert. Dies führt zu unerwünschten zusätzlichen optischen Vielfachreflektionen und optischen Interferenzeffekten an den Stellen, an denen sich der Brechungsindex abrupt ändert. Ferner wurden die Vorteile, welche eine beliebig auf einen längeren Teilabschnitt verteilte kontinuierliche Phasenverschiebung bietet, bei weitem nicht ausgeschöpft.

Eine weitere bekannte Lösung beinhaltet eine mit der z-Richtung lineare Änderung der lateralen Streifenbreite der aktiven Schicht und benachbarter Schichten über einen longitudinalen Teilabschnitt des Bauelements, um die Phasenverschiebung örtlich zu verteilen [z. B. Y. Nakano et al., IEEE J. Q. Electron 24, 2017 (1988), oder J. Kinoshita et al. IEEE J. Q. Electron 27, 1759 (1991)]. Nicht alle Vorteile, welche eine beliebige, kontinuierliche Verteilung der Phasenverschiebung bietet, wurden genutzt.

Bekannt ist weiterhin die sinusförmige Brechungsindex-Variation mittels in axialer Richtung variierter Streifenbreite. Diese Lösung wurde theoretisch vorgeschlagen, um eine vollständige Einmodigkeit zu erreichen [K. Tada et al. Electron. Lett. 20, 82 (1984)].

Ferner ist eine kontinuierliche Brechungsindex-Variation in axialer Richtung theoretisch beschrieben worden [J. Lightwave Technol. 11, 1325 (1993)]. Die axiale Variation des Brechungsindex wird durch laterale symmetrische Reduktion der Gitterfeldbreite in einem optischen Wellenleiter angedeutet.

Desweiteren ist eine Lösung zur Erzeugung von Phasenverschiebungen bekannt, die auf einer Aufweitung der vertikalen Dicke der aktiven Schicht oder benachbarter Wellenleiterschichten über eine bestimmte Länge der longitudinalen Bauelementelänge beruht [z.B. B. Broberg, et al. Appl. Phys. Lett 47, 4 (1985) oder K. Kojima et al. J. Ligthwave Technol. LT-3, 1048 (1985)]. Dies führt zu unerwünschten zusätzlichen optischen Vielfachreflektionen und optischen Interferenzeffekten an den Stellen, an denen sich der Brechungsindex abrupt ändert. Ferner wurden die Vorteile, welche eine beliebig auf einen längeren Teilabschnitt verteilte kontinuierliche Phasenverschiebung ermöglicht, bei weitem nicht ausgeschöpft.

Weitere bekannte Lösungen beinhalten die Erzeugung einer Phasenverschiebung über die axiale Variation der Gitterperiode.

In der Literatur sind Beispiele für die abrupten Änderungen der Gitterperiode in axialer Bauelementerichtung angeführt. In der zentral gelegenen Sektion des Laser-Resonators wurde holographisch eine größere Gitterperiode realisiert als in den Seitensektionen. Diese Struktur konnte erfolgreich zur Reduktion der optischen Linienbreite genutzt werden [M. Okai et al., IEEE J.Quantum electron. 27, 1767 (1991)]. Der mittlere Bereich geänderter Gitterperiode dient der Erzeugung der Phasenverschiebung. Es wurden mit dieser Struktur abrupte Gitterperioden-Änderungen erzeugt. Es wurden jedoch nicht alle Vorteile, welche eine kontinuierliche Variation des Kopplungskoeffizienten bietet, ausgeschöpft.

In gewissem Rahmen ermöglicht auch die Elektronenstrahl-Lithographie (EL) die Realisierung von im Ortsraum verteilten Phasenverschiebungen über die Änderung der Gitterperiode in longitudinaler Richtung. Allerdings ist bei diesem Verfahren die Differenz zwischen benachbarten Gitterperioden auf größere Werte begrenzt. Dadurch können mit EL lediglich DFB-Gitter hergestellt werden, welche eine kleine Anzahl verschiedener Sektionen aufweisen, innerhalb denen die Gitterperiode konstant ist, sich jedoch von Sektion zu Sektion unterscheidet. Es können keine quasikontinuierlichen Variationen der Gitterperiode mit dem Ort erreicht werden. Ferner ist EL ein kompliziertes Verfahren und die EL-Schreibzeit ist sehr teuer.

Gekrümmte Wellenleiter auf homogenen DFB- oder DBR-Gitterfeldern können, wie bereits bekannt, zur Definition von Gittern mit axial variierender Gitterperiode genutzt werden. Mit dieser Methode können auch definierte Phasenverschiebungen über eine gezielte axiale Variation der Gitterperiode erzeugt werden und gleichzeitig die Phasenverschiebungen axial beliebig und, quasikontinuierlich verteilt werden.

Die erfindungsgemäße Aufgabe besteht darin, ein Verfahren zu entwickeln, durch das optoelektronische Bauelemente, welche durch eine definierte axiale Variation des Kopplungskoeffizienten und eine definierte Verteilung der Phasenverschiebung gekennzeichnet sind, mit einfachen Mitteln und möglichst kostengünstig hergestellt werden können. Bei entsprechend tiefer Ätzung ist dabei eine starke, zusätzliche laterale Wellenführung erreichbar. Eine axial verteilte Phasenverschiebung wird erreicht unter Vermeidung der bei vielen anderen Verfahren auftretenden zusätzlichen, störenden Reflektionen an den axialen Enden derjenigen Zonen, welche die Phasenverschiebung erzeugen oder eine Sektion mit geändertem Kopplungskoeffizienten darstellen.

Die erfindungsgemäße Lösung betrifft optoelektronische Bauelemente, mit einer periodisch strukturierten Grenzfläche zwischen zwei Halbleiter-Schichten mit unterschiedlichen Brechungsindizes, die eine optische Rückkopplung des geführten Lichtes bewirkt (DFB- oder DBR-Gitter; DFB = distributed feedback; DBR = distributed Bragg reflector). Wichtigstes Merkmal der Struktur sind die besonders angeordneten und charakteristisch begrenzten DFB- oder DBR-Gitter, wobei die verteilte optische Rückkopplung durch in longitudinaler Richtung periodisch strukturierte Materialgitter realisiert wird, so daß eine periodische Variation des Real- und/oder Imaginärteils des Brechungsindex erreicht wird. Der Kern des optoelektronischen Bauelements besteht hierbei aus verschiedenen Halbleiterschichtpaketen, die in vertikaler Richtung (y-Richtung) auf dem Halbleitersubstrat übereinander plaziert sind. Jedes dieser HalbleiterSchichtpakete ist in y-Richtung nicht notwendigerweise homogen, sondern kann auch seinerseits wieder aus verschiedenen Einzelschichten oder aus kontinuierlichen Übergängen zwischen verschiedenen Halbleiterschichten aufgebaut sein. Jedes Halbleiter-Schichtpaket wird daher im folgenden vereinfachend auch als Quasi-Einzelschicht benannt, d. h. mit dem Begriff "Halbleiterschicht" bezeichnet.

Die Bezeichnung Halbleiterschicht beinhaltet im Falle der laseraktiven Halbleiterschicht z. B. auch eine Anzahl von Potentialtöpfen (quantum wells) und eine dementsprechend ausreichende Anzahl von Potentialbarrieren. Im folgenden ist unter dem Brechungsindex einer Halbleiterschicht der innerhalb dieses Halbleiterschichtpakets gemittelte Brechungsindex zu verstehen. Unterhalb der ersten Halbleiterschicht ist das Halbleitersubstrat angeordnet. Das vertikale Dotierungsprofil der Struktur ist nach bekannten Halbleiterlaser-Design-Prinzipien ausgestaltet. Falls es sich bei dem optoelektronischen Bauelement um einen Laser handelt, befindet sich der pn-Übergang in der Nähe oder in der aktiven Halbleiterschicht. Dabei ist sowohl n-leitendes als auch p-leitendes Halbleitersubstrat anwendbar. Im Folgenden wird unter dem Begriff "Halbleiterwafer" entweder das Halbleitersubstrat, oder auch das Halbleitersubstrat mit einer bestimmten Anzahl von geeignet aufgewachsenen Halbleiterschichten verstanden.

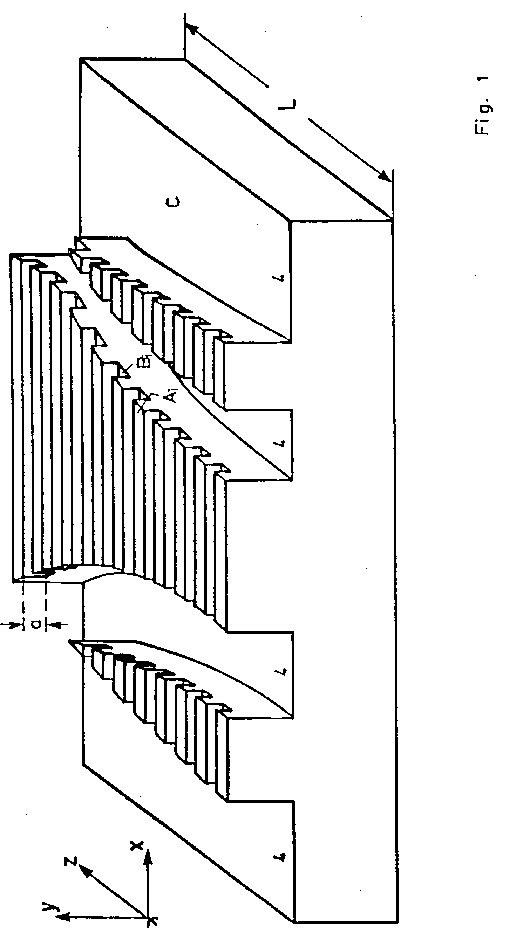

Das Gitter weist in axial = longitudinaler Richtung (z-Richtung) eine konstante Gitterperiode $\Lambda$, eine konstante Gittergrabentiefe a und ein konstantes Tastverhältnis $W/\Lambda$ auf $(0 < W < \Lambda)$, erstreckt sich jedoch in lateraler Richtung (x-Richtung) nach dem in diesem Verfahren beschriebenen Strukturierungsschritt nicht über die gesamte Bauelemente-Breite, sondern weist charakteristische Begrenzungen auf. Diese Gitterbegrenzungen trennen die Bereiche mit Gittergräben, die sich über die gesamte longitudinale Länge des optoelektronischen Bauelements erstrecken können, von den gitterfreien Bereichen ab. Aus Gründen der Übersichtlichkeit wurde in den Abbildungen 1 bis 3 ein Tastverhältnis des Gitters von $W/\Lambda = 0.5$ gewählt.

Ausgangspunkt für das erfindungsgemäße Verfahren ist ein optoelektronisches Halbleiterbauelement, das aus einem Halbleitersubstrat mit in vertikaler Richtung auf dem Halbleitersubstrat angeordneten Halbleiterschichten besteht, und das mit einer DFB- oder DBR-Gitterstruktur der Gittergrabentiefe a versehen ist.

Das erfindungsgemäße Verfahren beruht auf an sich bekannten Prinzipien der Halbleiterstrukturierung mittels Photolack, Aufdampfverfahren, Sputterverfahren und Ätzprozessen.

Erfindungsgemäß wird nach dem Aufschleudern des Photolacks auf die Gitterstruktur des Halbleiterwafers die Belichtung des Photolacks unter Einbeziehung von Photomasken vorgenommen. Mittels der Photomaske werden die für das optoelektronische Bauelement gewünschten mathematischen Formen der gekrümmten Gitterfeld-Begrenzungen durch entsprechende Ausbildung der Photomaske in Bezug auf die laterale und axiale Geometrie definiert. Das heißt, die auf der Photomaske enthaltenen geometrischen Formen bestimmen u. a. die mathematischen Funktionen der Begrenzungen zwischen den Bereichen mit Gittergräben und den gitterfreien Bereichen und damit wesentliche Parameter des optoelektronischen Bauelements.

Je nach angestrebter Anwendung des optoelektronischen Bauelements wird mittels rechnerischer Optimierung die Bauelemente-Geometrie, die Brechungsindizes der einzelnen Halbleiter-Schichten, sowie insbesondere die mathematischen Funktionen, die den Verlauf der Gitterbegrenzungen charakterisieren, ermittelt. Durch die in longitudinaler Richtung quasi-kontinuierlich variierende laterale Breiten der Bereiche mit Gittergräben sowie der gitterfreien Teilbereiche wird eine definierte und quasi-kontinuierliche axiale Änderung des lateralen effektiven Brechungsindex und des Kopplungs-Koeffizienten erreicht.

Als Ätzmaske für den Strukturierungsschritt kann die entwickelte Photolackstruktur selbst dienen, oder eine mittels Liftoffs erzeugte Metall- oder Isolatorfilmstruktur. Im Fall eines Liftoffprozesses wird auf dem entwickelten Photolack eine dünne Isolatorschicht oder Metallschicht oder beides aufgebracht.

Die erfindungsgemäße Lösung wird anhand einiger Ausführungsbeispiele näher erläutert:

Figur 1 zeigt die perspektivische Ansicht eines Halbleiterwafers für ein optoelektronisches Bauelement nach dem beschriebenen Strukturierungsschritt, welcher die Gitterbegrenzungen der für dieses Beispiel gewählten drei Bereiche mit Gittergräben definiert hat.

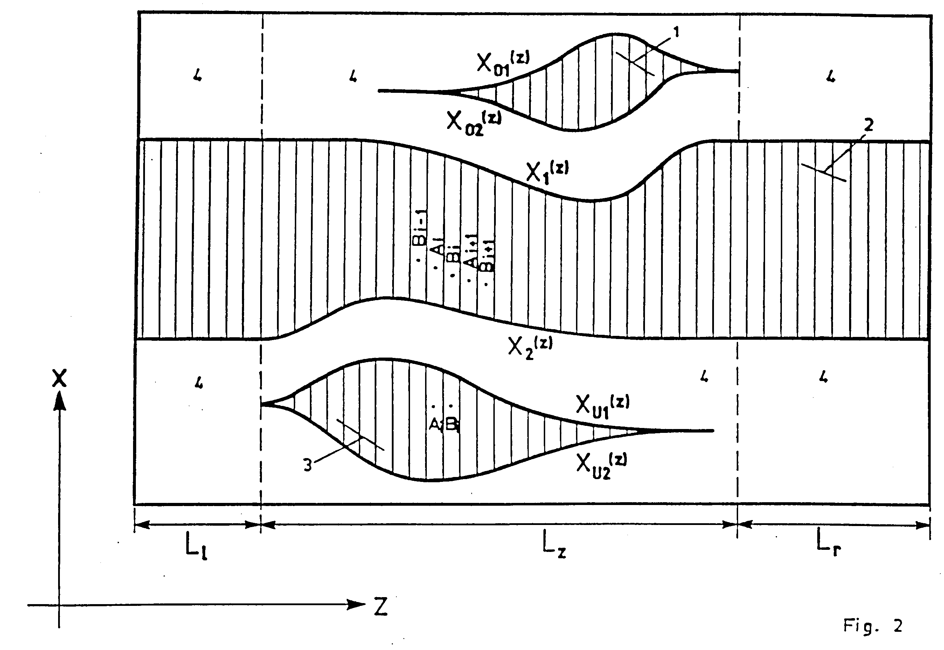

Figur 2 zeigt eine Aufsicht auf eine mögliche Anordnung von drei Gitterfeldern nach Ausführung des Strukturierungsschrittes Die Bereiche mit Gittergräben werden in diesem Beispiel durch die gekrümmt oder gerade verlaufenden Funktionen $x_1(z)$, $x_2(z)$, $x_{o1}(z)$, $x_{o2}(z)$, $x_{u1}(z)$, und $x_{u2}(z)$ von den gitterfreien Bereichen abgegrenzt.

Ein wesentlicher Punkt der erfindungsgemäßen Lösung ist die Realisierung der Gitterbegrenzungen $x_1(z)$, $x_2(z)$, $x_{o1}(z)$, $x_{o2}(z)$, $x_{u1}(z)$ und $x_{u2}(z)$. Zunächst wird das DFB- oder DBR-Gitter über eine größere laterale Breite d ($10\mu m > d > 2\mu m$) oder ganzflächig in die Oberfläche des Halbleiterwafers mit einer einheitlichen Gittergrabentiefe a definiert.

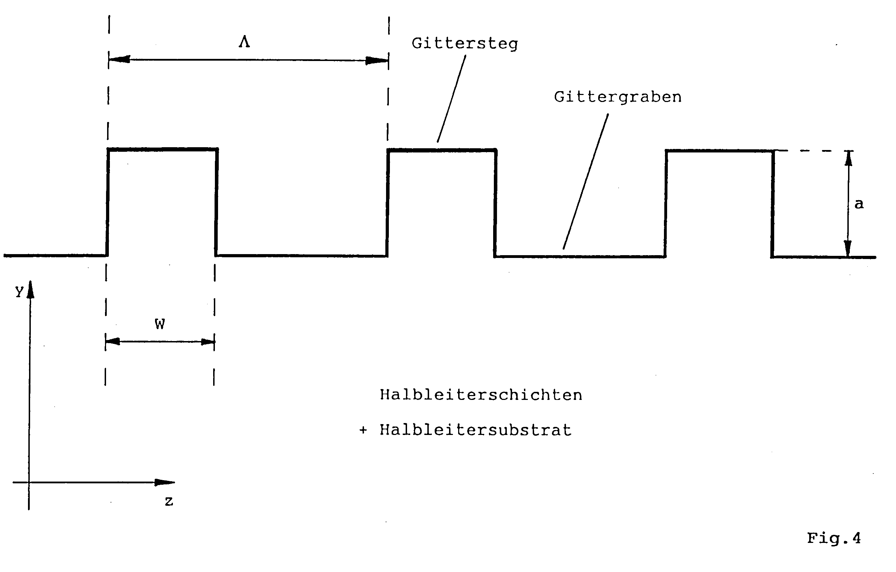

Das Gitter kann in einem Schnitt in der yz-Ebene entweder eine Rechteckform (Fig.4), eine Dreieckform, eine Sinusform oder Mischform aufweisen. In Fig.4 ist der Fall eines asymmetrischen Tastverhältnisses abgebildet: Das heißt, 2W ist nicht gleich λ.

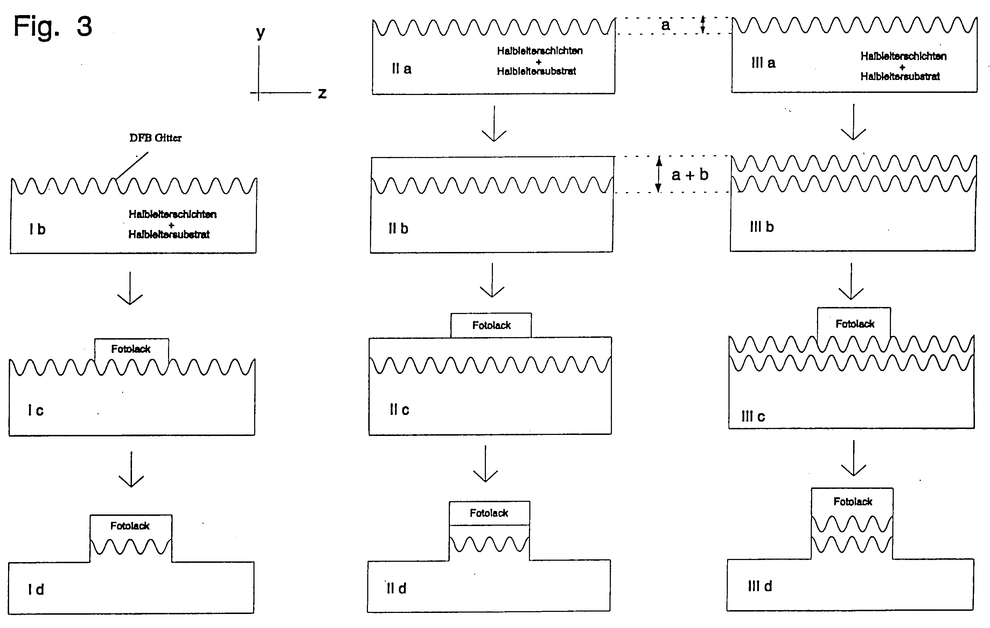

Bezüglich der vertikalen Position der Fotolackschicht, mit der in einem Strukturierungsschritt die laterale Gitterbegrenzung erzeugt wird, sind zwei Varianten möglich (siehe Figur 3). Entweder wird der Fotolack direkt auf das DFB oder DBR-Gitter aufgebracht (Figur 3 I: b = 0), oder das Gitter wird vor dem Aufbringen des Fotolacks mit einer weiteren Halbleiterschichtenfolge der Dicke b bedeckt. In dieser zweiten Variante (Figur 3 II und Figur 3 III: b ungleich 0 ) wird der Fotolack auf die Oberfläche dieser Halbleiterschichtenfolge der Dicke b aufgebracht. Dabei kann die Halbleiterschichtenfolge der Dicke b bei ihrem Wachstum entweder bezüglich des Gitters planarisierend wirken (Figur 3 III), oder dieselbe Gitterstruktur an deren Oberfläche wieder reproduzieren (Figur 3 II). Entsprechende Mischformen geben den am häufigsten auftretenden Fall wieder. In Figur 1 ist die erste Variante, d. h. b = O, dargestellt. Diese Variante wird aus Gründen der Übersichtlichkeit in den Beispielen weiter beschrieben.

In Figur 3 und im folgenden ist der einfachere Fall beschrieben, in dem die Strukturierung direkt mit der entwickelten Fotolackstruktur (also ohne Metall- oder Isolatorfilmstruktur) vorgenommen wird. Mittels einer Fotomaske, deren geometrische Form mittels mathematischer Methoden in Abhängigkeit von den gewünschten Parametern des optoelektronischen Bauelements festgelegt wurde, werden jene Bereiche festgelegt, in denen der Fotolack belichtet wird, sowie auch die komplementären Bereiche, in denen der Fotolack unbelichtet bleibt. Nach der Entwicklung des Fotolacks sind bestimmte Bereiche des Gitters in der xz-Ebene noch mit Fotolack geschützt und andere nicht (Figur 3: Ic, IIc, IIIc). In den offenliegenden ungeschützten Bereichen wird das Gitter in einem nachfolgenden Strukturierungsschritt mittels eines naßchemischen Ätzverfahrens oder eines Trockenätzverfahrens vollständig entfernt, wobei ein Materialabtrag um mindestens die Tiefe a bzw. a + b vorgenommen wird (siehe Fig.1 und Fig. 3: Id, IId, IIId). Dabei entstehen die gitterfreien Bereiche 4 in der xz-Ebene (siehe Fig. 1 und Fig. 2). Die Punkte C liegen auf den gitterfreien Bereichen 4. Nachfolgend wird die Struktur mit einem Halbleitermaterial überwachsen, wobei sich dessen Brechungsindex von dem Brechungsindex der Halbleiterschicht unterscheidet, in welche das Gitter definiert wurde.

Es sollen nun zwei Ausführungsmöglichkeiten des Beispiels erläutert werden. In der ersten Ausführungsmöglichkeit wurde das Gitter direkt in das Halbleitersubstrat definiert. Nachfolgend wird diese Struktur mit einem Halbleitermaterial überwachsen, welches einen höheren Brechungsindex als das Halbleitersubstrat aufweist. Die genaue Schichtenfolge oberhalb des Halbleitersubstrats variiert je nach Anwendung des optoelektronischen Bauelements. Im Falle eines Halbleiterlasers liegt das laseraktive Schichtpaket in dieser Ausführungsmöglichkeit oberhalb des Gitters.

In der zweiten Ausführungsmöglichkeit wurde das Gitter in eine auf das Halbleitersubstrat bereits aufgebrachte Schichtenfolge mit der Gittertiefe a strukturiert. Danach werden die Begrenzungen der Gitterbereiche in einem nachfolgenden Strukturierungsschritt derart festgelegt, daß auf der gesamten xz-Ebene (siehe Fig. 1 und 2) partiell ein Materialabtrag um mindestens die Tiefe a erfolgt, so daß die gitterfreien Bereiche 4 entstehen. Befinden sich die wellenleitenden Halbleiterschichten mit höherem Brechungsindex unterhalb des Gitters, so wird diese Struktur mit einem Halbleitermaterial überwachsen, welches einen kleineren Brechungsindex aufweist, als das Halbleitermaterial, in welches das Gitter definiert wurde. Die genaue Schichtenfolge unterhalb und oberhalb des Gitters variiert je nach Anwendung des optoelektronischen Bauelements. Im Falle eines Halbleiterlasers liegt das laseraktive Schichtpaket in dieser Ausführungsmöglichkeit unterhalb des Gitters.

Entscheidend für das vorgeschlagene Bauelement ist die mathematische Form der Krümmungskurven der Gitterbegrenzungen. Ganz besonderes Gewicht kommt dabei den Funktionen $x_1 = x_1(z)$ und $x_2 = x_2(z)$ zu, welche den zentralen Bereich mit Gittergräben von den lateral benachbarten gitterfreien Teilbereichen abtrennen (siehe Fig. 1 und 2). Durch die quasi-kontinuierlich in longitudinaler Richtung variierende laterale Breite der Gitterbegrenzungen $[x_1(z) - x_2(z)]$ wird eine definierte und quasi-kontinuierliche Änderung des effektiven Brechungsindex und des Kopplungskoeffizienten erreicht. Durch entsprechende Wahl der Form der Gitterbegrenzungen $x_1 = x_1(z)$, $x_2 = x_2(z)$, $x_{o1} = x_{o1}(z)$, $x_{o2} = x_{o2}(z)$, $X_{u1} = x_{u1}(z)$ und $x_{u2} = x_{u2}(z)$, können verschiedenartigste Verteilungen des lateralen effektiven Brechungsindex in longitudinaler Richtung (z-Richtung) erreicht werden. Die Teillängen $L_l$ und $L_r$, auf denen sich, wie in Fig. 2 abgebildet, die Differenz der lateralen Breite $[x_1(z) - x_2(z)]$ nicht ändert, können im Grenzfall auch die Länge Null haben, bzw. auch in der Mitte des Bauelements der Gesamtlänge L liegen.

Eine Verjüngung des Bereichs mit Gittergräben 2 in seinem mittleren Bereich (siehe Fig. 2) führt ebenso wirkungsvoll zu einer definierten Phasenverschiebung und einer Variation des Kopplungskoeffizienten wie eine entsprechende Verbreiterung.

Je nach angestrebter Anwendung des optoelektronischen Bauelements muß eine rechnerische Optimierung der Bauelemente-Geometrie, der Brechungsindex-Werte, sowie insbesondere der mathematischen Funktionen der Gitterbegrenzungen $x_1 = x_1(z)$, $x_2 = x_2(z)$, $x_{o1} = x_{o1}(z)$, $x_{o2} = x_{o2}(z)$, $X_{u1} = x_{u1}(z)$ und $x_{u2} = x_{u2}(z)$ durchgeführt werden.

Wichtig ist, daß der vertikale effektive Brechungsindex der vollständigen Laserstruktur in den gitterfreien Bereichen verschieden ist von dem vertikalen effektiven Brechungsindex der Gitterfelder. Letzterer ist für diesen Vergleich über eine quadratische Fläche mit parallel zu den Gitterstegen liegenden Kantenlängen 2$\Lambda$ zu mitteln.

In Figur 1 und 2 werden jeweils Ansichten und Teilansichten eines optoelektronischen Bauelements mit DFB-Gitter dargestellt. Es ist jedoch auch die Verwendung von DBR-Gittern möglich, in denen es in longitudinaler Richtung ebenfalls völlig gitterfreie Bereiche gibt. Im Fall, daß es sich bei dem optoelektronischen Bauelement um einen Laser handelt, muß sich die laseraktive Halbleiterschicht nicht zwangsläufig in lateraler Richtung x über die gesamte Bauelemente-Fläche erstrecken. Sie muß jedoch in diesem Beispiel in jedem Fall unter bzw. über dem zentralen, gittertragenden Bereich 2 liegen. Die Strominjektion in die aktive Halbleiterschicht wird lateral gesehen sinnvollerweise auf jene Teile der laseraktiven Schicht begrenzt, welche nahe dem Maximum des geführten Lichtes liegen. Elektrisch gepumpt wird somit nur ein Streifen mit einer Länge von etwa L und einer lateralen Breite, die etwas größer oder von vergleichbarer Größe wie das Maximum von $[x_1(z) - x_2(z)]$ ist, welches im Bereich $0 < z < L$ liegt. Die laterale Ausführung der laseraktiven Schicht, sowie die Ermöglichung der Strominjektion kann nach bekannten Bauelemente-Design-Prinzipien erfolgen, z. B. in Form einer vergrabenen Laserstruktur (buried heterostructure) oder einer Rippenstruktur (ridge structure).

Die zahlenmäßige Größe des Kopplungskoeffizienten K wird vor allem bestimmt durch die Tiefe der Gittergräben a, den lokalen lateralen Abstand der Gitterbegrenzungen $[x_1(z) - x_2(z)]$voneinander, sowie durch das Tastverhältnis $W/\Lambda$ und in geringerem Maße auch durch den Verlauf von $x_{o1}(z)$, $x_{o2}(z)$, $x_{u1}(z)$ und

$x_{u2}(z)$. Der lokale Kopplungskoeffizient an der Stelle $z_i$ ergibt sich rechnerisch aus dem lokalen, lateralen Überlapp der Gitterbereiche mit der Lichtintensitäts-Verteilung in den xy-Schnittebenen an der Stelle $z_i$ im Bauelement. Die Wellenführung (Intensitätsverteilung des geführten Lichtes in der xy-Ebene) wird durch Lösung der Maxwellschen Gleichungen mit Randbedingungen für die Zentralwellenlänge des Bauelements ermittelt. Die Zentralwellenlänge ist z. B. die angestrebte Bragg-Wellenlänge eines Ein-Sektions-DFB-Lasers oder z. B. die Wellenlänge, um die herum in einem Mehr-Sektions-Bauelement eine Wellenlängenabstimmung erfolgen soll. Die Wellenführung in der xy-Ebene wird durch die Brechungsindex-Variation in dieser Ebene festgelegt. Die vertikalen Dicken und die Brechungsindizes der einzelnen Halbleiter-Schichten werden so gewählt, daß bei einer Zentralwellenlänge eine gute Wellenführung erreicht wird, unter Berücksichtigung der lateralen Dimensionen der einzelnen Halbleiter-Schichten und deren lateralen Brechungsindex-Variationen, die insbesondere auch durch $x_1(z)$; $x_2(z)$; $x_{01}(z)$; $x_{o2}(z)$; $x_{u1}(z)$ und $x_{u2}(z)$ gegeben ist.

Die Berechnung des Betrags der Phasenverschiebung aus dem mathematischen Verlauf $x_1(z)$, $x_2(z)$, $x_{o1}(z)$, $x_{o2}(z)$, $x_{u1}(z)$ und $x_{u2}(z)$ läßt sich über verschiedene Methoden realisieren. Eine mögliche Methode stellt eine Näherungslösung dar, die durch das sequenzielle rechnerische Lösen mehrerer eindimensionaler Wellengleichungs-Probleme charakterisiert ist.

1. Berechnung der Wellenführung in y-Richtung für die Zentral-Wellenlänge [siehe z. B. S. Hansmann, J. Ligthwave Technol. 10, 620 (1992)]:

Die Punkte $A_1$, ... $A_i$, ... $A_p$ liegen in z-Richtung gesehen jeweils in der Mitte der Gitterstege. Die Punkte $B_1$, ... $B_i$ ... $B_p$ liegen in z-Richtung gesehen jeweils in der Mitte der Gittergräben. Die Positionen der Punkte in z-Richtung werden mit $z_{Ai}$ bzw. $z_{Bi}$ bezeichnet.

a) An der Stelle $A_i$:

Im Ausführungsbeispiel in Fig. 2 liegen an den Stellen $(...A_{i-1}, A_i, A_{i+1}, ...)$ durch die Strukturierung der Halbleitergrenzfläche, in welcher das Gitter liegt, jeweils Gitterstege.

In die Rechnung gehen die einzelnen Schichtdicken in y-Richtung und die entsprechenden Brechungsindizes ein. Aus der Rechnung resultiert ein effektiver vertikaler Brechungsindex $n_{eff,y}$ (A). An allen Punkten $(...A_{i-1}, A_i, A_{i+1}, ...)$ liegt in Fig. 1 und 2 derselbe vertikale effektive Brechungsindex vor, wenn sich die Halbleiter-Schichtenfolge über die in den Abbildungen gezeigte laterale Breite des zentralen Gitterfeldes erstreckt.

b) Für eine bestimmte Gittergraben-Tiefe a an der Stelle $B_i$:

An den Punkten $(..., B_{i-1}, B_i, B_{i+1}, ...)$ existieren im Ausführungsbeispiel in Figur 1 und 2 jeweils Gittergräben. Daraus resultiert in Fig. 2 an allen Stellen $(..., B_{i-1}, B_i, B_{i+1}, ...)$ derselbe effektive Brechungsindex $n_{eff,y}$ (B) in y-Richtung, wenn sich die Halbleiter-Schichtenfolge über die in den Abbbildungen dargestellte laterale Breite des zentralen Gitterfeldes erstreckt.

c) An einer Stelle C, welche in den gitterfreien Bereichen liegt. Falls sich z. B. die laseraktive Schicht oder eine andere Halbleiterschicht nicht über die gesamte laterale Breite erstreckt, in welcher das Lichtfeld mit nennenswerter Intensität geführt wird, ist diese Grenze zusätzlich entsprechend zu berücksichtigen.

2. Berechnung der Wellenführung in x-Richtung für die Zentral-Wellenlänge längs einem Schnitts an allen Stellen $A_1...A_i...A_p$ und $B_1...B_i...B_p$, unter Berücksichtigung der Ergebnisse von Punkt 1. Dabei ist p die Gesamtzahl der Gittergräben im Bauelement. [Die korrespondierenden Gittergräben in den verschiedenen Bereichen mit Gittergräben (1;2;3) werden dabei nicht doppelt gezählt, siehe Fig. 2].

In die Rechnung geht entscheidend die Breite $[x_1(z)-x_2(z)]$ des zentralen Gitterbereichs ein. Aus der Rechnung resultiert im Prinzip an jeder Stelle $z_{Ai}$ und $z_{Bi}$ ein unterschiedlicher Brechungsindex $n_{eff,xy}$ - $(z_{Ai},a)$ und $n_{eff,xy}$ $(z_{Bi},a)$. Durch die quasikontinuierlichen Funktionen $x_1 = x_1(z_i)$, $x_2 = x_2(z_i)$, $x_{o1} = x_{o1}(z_i)$, $x_{o2} = x_{o2}(z_i)$, $x_{u1} = x_{u1}(z_i)$ und $x_{u2} = x_{u2}(z_i)$ ergibt sich somit eine quasi-kontinuierliche axiale Änderung des Brechungsindex $n_{eff,xy}$ $(z_{Ai},a)$ und $n_{eff,xy}$ $(z_{Bi},a)$ Für den Gittersteg, auf dem der Punkt $A_i$ liegt, wird als laterale Gitterstegbreite näherungsweise die Breite $[x_1(z_{Ai}) - x_2(z_{Ai})]$ verwendet. Entsprechendes gilt für alle Punkte $A_1$ ... $A_i$ ... $A_p$.

Für den Gittergraben, in dem der Punkt $B_i$ liegt, wird als laterale Gittergrabenbreite näherungsweise die Breite $[x_1(z_{Bi}) - x_2(z_{Bi})]$ verwendet. Entsprechendes gilt für alle Punkte $B_1$ ... $B_i$ ... $B_p$. Ebenso wird mit den anderen Begrenzungen $x_{o1}(z)$, $x_{o2}(z)$ und $x_{u2}(z)$ verfahren.

Eine weitere Methode der Berechnung der axialen Variation des Brechungsindex in der xy-Ebene aus dem mathematischen Verlauf $x_1(z)$, $x_2(z)$, $x_{o1}(z)$, $x_{o2}(z)$, $x_{u1}(z)$ und $x_{u2}(z)$ beruht in Teilen der Rechnung auf einem effektiv zweidimensionalen Wellengleichungsmodell an allen Punkten $A_i$ und $B_i$. In die Rechnung geht der Brechungsindex-Verlauf in allen xy-Ebenen ein, welche durch die Punkte $A_i$ und $B_i$ gehen und als Normale die z-Achse besitzen. Die rechnerische Lösung dieses Problems ist wesentlich komplizierter, führt jedoch unmittelbar zu den Werten $n'_{eff,xy}(z_{Ai},a)$ und $n'_{eff,xy}(z_{Bi},a)$. Diese Rechnung wird an allen Punkten $A_1...A_i...A_p$ und $B_1...B_i...B_p$ durchgeführt.

Die Ergebnisse des ersten Verfahrens stellen eine Näherungslösung der präziseren Ergebnisse des zweiten Verfahrens dar. Im folgenden wird zwischen $n'_{eff,xy}(z_{Ai},a)$ und $n_{eff,xy}(z_{Ai},a)$ sowie zwischen $n'_{eff,xy}(z_{Bi},a)$ und $n_{eff,xy}(z_{Bi},a)$ jedoch nicht unterschieden.

Es werden nun folgende Größen definiert und verwendet:

| | |
|---|---|
| W | = longitudinale Gitterstegbreite |
| $[\Lambda - W]$ | = longitudinale Gittergrabenbreite |
| $\beta$ | = Wellenvektor |
| $\lambda_o$ | = Wellenlänge des Lichtes im Vakuum |
| $\beta(z_i)$ | = Wellenvektor an der Stelle $z_i$ |

Ferner:

$$z_j = (z_{Ai} + z_{Bi})/2 \qquad (\text{für } j = i)$$

$$n_{eff,xy}(z_j) = \left[ \frac{W}{\Lambda} \, n^2_{eff,xy}(z_{Ai}) + [1 - \frac{W}{\Lambda}] \, n^2_{eff,xy}(z_{Bi}) \right]^{0,5}$$

$$(1)$$

Für die Definition der Phasenverschiebung gibt es mehrere Möglichkeiten. Zwei einfache Möglichkeiten, welche Näherungen beinhalten, sind im folgenden angegeben: Erstens, der Bezug auf eine Vergleichsphase, welche für feste Werte von a, sowie festgehaltene Funktionen $x_1(z)$; $x_2(z)$; $x_{o1}(z)$; $x_{o2}(z)$; $x_{u1}(z)$ und $x_{u2}(z)$ mit dem minimalen Wert $n_{eff,xy}(z_j) = n_{eff,mi}$ mathematisch verknüpft ist, oder zweitens, der Bezug auf eine Vergleichsphase, welche mit dem maximalen Wert $n_{eff,xy}(z_j) = n_{eff,ma}$ mathematisch zusammenhängt. Dabei ist $n_{eff,ma}$ der maximale und $n_{eff,mi}$ der minimale Wert von allen $n_{eff,xy}(z_j)$, welche in longitudinaler Richtung an den Punkten $z_j$ vorkommen. Mögliche Werte j sind ganzzahlig und liegen im Bereich $1 \leq j \leq p$. Im folgenden steht $n_{eff,m}$ für $n_{eff,ma}$ oder $n_{eff,mi}$, nachdem, welche Wahl bei der Definition getroffen wurde. Die Wellenvektordifferenz errechnet sich nach $\Delta\beta = \beta(z_j) - \beta_m$, wobei $\beta_m$ mit $n_{eff,m}$ verknüpft ist. Der Wellenvektor an der Stelle $z_j$ ist folgendermaßen definiert:

$$\beta(z_j) = \frac{2\pi}{\lambda_o} \cdot n_{eff,xy}(z_j) \qquad (2)$$

Die Phasenverschiebung $\Delta\phi$, welche an der Stelle $z_j$ innerhalb einer Gitterperiode erzeugt wird, errechnet sich gegenüber einer mit $n_{eff,m}$ verknüpften Gitterperiode nach

$$\Delta\phi_j = \Lambda \cdot \Delta\beta(z_j) \qquad (3)$$

Die gesamte Phasenverschiebung des Gitters ergibt sich aus der Summe der Phasenverschiebungsanteile jeder einzelnen Gitterperiode.

$$\Delta\varphi = \sum_{j=1}^{p} \Lambda \cdot \Delta\beta(z_j) \qquad (4)$$

Der Abstand $[x_1(z) - x_2(z)]$ kann zwischen $0,1\mu m$ und $5\mu m$, je nach Anforderung an das Bauelement, durch entsprechende Wahl der Funktionen $x_1(z)$ und $x_2(z)$ gewählt werden. Der Abstand $[x_{o1}(z) - x_{o2}(z)]$ bis $[x_{u1}(z) - x_{u2}(z)]$ kann zwischen $1\mu m$ und dem zwanzigfachen der Zentralwellenlänge liegen. Falls bei dem Bauelement laterale Einmodigkeit bei der Zentralwellenlänge erwünscht ist, muß bei der Dimensionierung auf einen genügend großen Unterschied bezüglich des "optical confinement" zwischen der lateralen Grundmode und der nächst höheren lateralen Mode geachtet werden. Je weniger die Differenz $[x_1(z) - x_2$-

(z)] in longitudinaler Richtung variiert wird, um so größer muß für eine festgehaltene Phasenverschiebung die Tiefe der Strukturierung der gitterfreien Bereiche C gewählt werden.

Beispiel: Zur Realisierung z. B. einer $\lambda$/4 Phasenverschiebung sorgt man durch Wahl der Begrenzungsfunktionen sowie der Brechungsindizes und der vertikalen Dicken der einzelnen Schichten dafür, daß $\Delta\phi = \pi$/2 wird.

Die Tiefe der Gittergräben a und die lokale Differenz [$x_1(z)$ - $x_2(z)$] bestimmen überwiegend die lokale Größe des Kopplungskoeffizienten K an der Stelle z. Der Kopplungskoeffizient K hängt ferner ab von dem Tastverhältnis W/$\Lambda$, den Begrenzungsfunktionen und dem detaillierten vertikalen Schichtaufbau (Dicke der einzelnen Halbleiterschichtpakete und deren Brechungsindizes).

- Je größer die Differenz der Gitterbegrenzungen [$x_1(z)$ - $x_2(z)$],
- je größer der Brechungsindexunterschied zwischen den beiden an das Gitter angrenzenden Halbleiterschichten und
- je tiefer die Gittergräben a, um so größer ist jeweils der Kopplungskoeffizient K.

Je größer die Änderung der Differenz der Gitterbegrenzungen [$x_1(z)$-$x_2(z)$] in longitudinaler Richtung ist, um so größer ist die longitudinale Variation des Kopplungskoeffizienten.

Die laterale Wellenführung wird durch die vorgeschlagene Struktur, insbesondere des lateralen Höhen- und Tiefenprofils der Grenzfläche, in welcher das Gitter liegt und insbesondere der Grenzflächen, welche in Fig. 1 zusätzlich freiliegen, automatisch unterstützt und herbeigeführt (siehe Fig. 1). Die laterale Wellenführung ist dabei um so größer, je größer der Brechungsindex Unterschied auf beiden lateralen Seiten des Gitters ist. Ferner hängt die laterale Wellenführung stark von der lateralen Position der Gitterbegrenzungen ab. Dabei ist der Beitrag von den äußeren lateralen Begrenzungen der Gitter $x_{o1}$, $x_{o2}$, $x_{u1}$ und $x_{u2}$ (in Fig. 2) zur lateralen Wellenführung nur spürbar, wenn diese so plaziert werden, daß sie in dem Bereich angeordnet sind, in dem das geführte Lichtfeld noch nennenswerte Intensität besitzt.

Die in der axialen Variation des effektiven Brechungsindex $n_{eff,xy}(z_{Ai},a)$ und $n_{eff,xy}(z_{Bi},a)$ enthaltenen Parameter (insbesondere die gekrümmt verlaufenden Begrenzungen, a, W/$\Lambda$ , die einzelnen Schichtdicken, deren laterale Ausdehnungen und deren Brechungsindizes) können optimiert werden, um Kenngrößen des optoelektronischen Bauelements zu verbessern. Erzielt werden können für einen Halbleiterlaser beispielsweise gleichzeitig einer oder mehrere der folgenden Vorteile:

- Kleinere spektrale Linienbreiten der optischen Emission
- reduziertes räumliches Lochbrennen und damit Verbesserung der longitudinalen Einmoden-Stabilität, sowie das Ermöglichen höherer optischer Leistungen,
- bessere Hochfrequenzeigenschaften, wie reduzierter Frequenz-Chirp und höhere Grenzfrequenzen unter hochfrequenter Modulation,
- stabilere longitudinale Einwelligkeit bei hoher optischer Ausgangsleistung,
- mögliche Schwellenstrom-Erniedrigung der Hauptmode (z. B. der Braggmode) und mögliche Schwellenstrom-Erhöhung der Seitenmoden,
- Linearisierung der Strom-Leistungskennlinie und Verbesserung der Lichtausbeute,
- Steigerung der Ausbeute an einmodigen Bauelementen oder an Bauelementen bestimmter Spezifikation und
- Vergrößerung des Wellenlängen-Durchstimmungsbereiches in Mehrsektionslasern.

Mit der erfindungsgemäßen Lösung wird eine äußerst präzise Einstellung der axialen Variation des Kopplungskoeffizienten und der axialen Verteilung der Phasenverschiebung in longitudinaler Richtung erreicht.

**Patentansprüche**

**1.** Verfahren zur Herstellung eines optoelektronischen Bauelements mit einer definierten Verteilung des Kopplungskoeffizienten und definierter Verteilung der Phasenverschiebung, wobei das optoelektronische Bauelement aus einem Halbleitersubstrat mit in vertikaler Richtung auf dem Halbleitersubstrat angeordneten Halbleiterschichten besteht und mit einer DFB- oder DBR-Gitterstruktur der Gittergrabentiefe a versehen ist, unter Anwendung an sich bekannter Prinzipien der Halbleiterstrukturierung mittels Photolack- und Ätztechniken, **dadurch gekennzeichnet**, daß nach dem Aufschleudern des Photolacks auf die Halbleiterschichtstruktur des Halbleiterwafers, dessen Halbleiterschichten so strukturiert sind, daß sich das DFB- oder DBR-Gitter immer zwischen dem aufgeschleuderten Photolack und dem Halbleitersubstrat befindet, die Belichtung des Photolacks unter Einbeziehung einer Photomaske erfolgt, die, entsprechend der für das optoelektronische Bauelement gewünschten Parameter, die laterale und axiale Geometrie der Gitterfelder des optoelektronischen Bauelements definiert, und die insbesondere auch die mathematischen Krümmungen der Gitterbegrenzungen zwischen den Bereichen mit Gittergräben und den gitterfreien Bereichen festlegt, daß danach mittels entsprechender Ätzverfahren ein auf die als gitterfreie Bereiche auszubildenden Flächen des optoelektronischen Bauelements begrenzter Materialabtrag erfolgt, wobei die Mindesttiefe des Materialabtrags eine horizontale xz-Ebene erreicht, welche der tiefsten Stellen der Gittergräben entspricht.

2. Verfahren nach Anspruch 1, dadurch gekennzeichnet, daß der Photolack direkt auf die Gitterstruktur des Halbleiterwafers aufgeschleudert wird, und daß der mittels Ätzverfahren auf der xz-Ebene vorzunehmende Materialabtrag gleicher Tiefe eine Mindesttiefe aufweist, die der Gittergrabentiefe (a) entspricht.

3. Verfahren nach Anspruch 1, dadurch gekennzeichnet, daß der Photolack auf eine oberhalb der Gitterstruktur des Halbleiterwafers aufgebrachte Halbleiterschichtenfolge der Gesamtdicke (b) aufgeschleudert wird, und daß der mittels Ätzverfahren auf der xz-Ebene vorzunehmende Materialabtrag gleicher Tiefe eine Mindesttiefe aufweist, die aus der Summe der Dicken der Halbleiterschichtenfolge (b) und der Gittergrabentiefe (a) resultiert.

Fig. 1

Fig. 2

Fig. 3

Fig.4